# EUROPEAN PATENT SPECIFICATION

(11) **EP 3 957 767 B1**
(45) Date of publication and mention of the grant of the patent: **10.12.2025**
(21) Application number: 20191464.5
(22) Date of filing: 18.08.2020
(51) Int. Cl.: C23C 14/56, C23C 16/44, C23C 16/54, H01L 21/67

(54) **VACUUM SYSTEM CLUSTER TOOL**
VAKUUMSYSTEMCLUSTERSWERKZEUG
ENSEMBLE D´OUTIL DE SYSTÈME SOUS VIDE

(43) Date of publication of application: 23.02.2022
(73) Proprietor: EMPA Eidgenössische Materialprüfungs- und Forschungsanstalt, 8600 Dübendorf (CH)
(72) Inventor: Guerra, Carlos, 8600 Dübendorf (CH); Petho, Laszlo, 8600 Dübendorf (CH); Michler, Johann, 8600 Dübendorf (CH); Szkudlarek, Aleksandra, Poland (PL)
(74) Representative: Keller Schneider Patent- und Markenanwälte AG

(56) References cited:
- CN-A- 110 835 726
- JP-A- H06 104 326
- US-A- 5 571 331
- US-A1- 2018 197 760

## Description

### TECHNICAL FIELD

The present invention describes a vacuum system cluster tool, comprising a dual chamber setup with at least one chemical vapour deposition chamber and at least one physical vapour deposition chamber.

### STATE OF THE ART

Today complex vacuum systems, combining different preparation techniques for sample surfaces are widely known. Such vacuum systems are keeping base pressures below 1x10⁻⁴ Pa (1x10⁻⁶ mbar) using appropriate gauges and pumps, which are usually controlled by at least one vacuum system control unit. To offer several preparation possibilities as for example thin film deposition, several chambers are connected at such a vacuum system, wherein usually each chamber allows at least one special preparation method. For subsequent application of different preparation steps, a transfer system for linear and/or rotational movement is necessary, allowing sample transfer under HV or UHV conditions of the sample stage or substrate holder between the different chambers.

Such a vacuum system is referred to as vacuum system cluster tool that combine two or more thin film deposition techniques like chemical vapor deposition (CVD, ALD) and physical vapor deposition (PVD) techniques, consist of multiple chambers, comprising at least one load lock and mechanical transfer means to move the sample from one chamber to another. This is a time consuming process, often not automated, and has a significant high cost of acquisition and operation. The in-situ deposition treatment of sample surfaces or substrates, mostly combines a cascade of different treatment steps, is important in the semiconductor industry, for wafer preparation. The aim is to perform as many different deposition steps or treatment steps as possible in the shortest possible time.

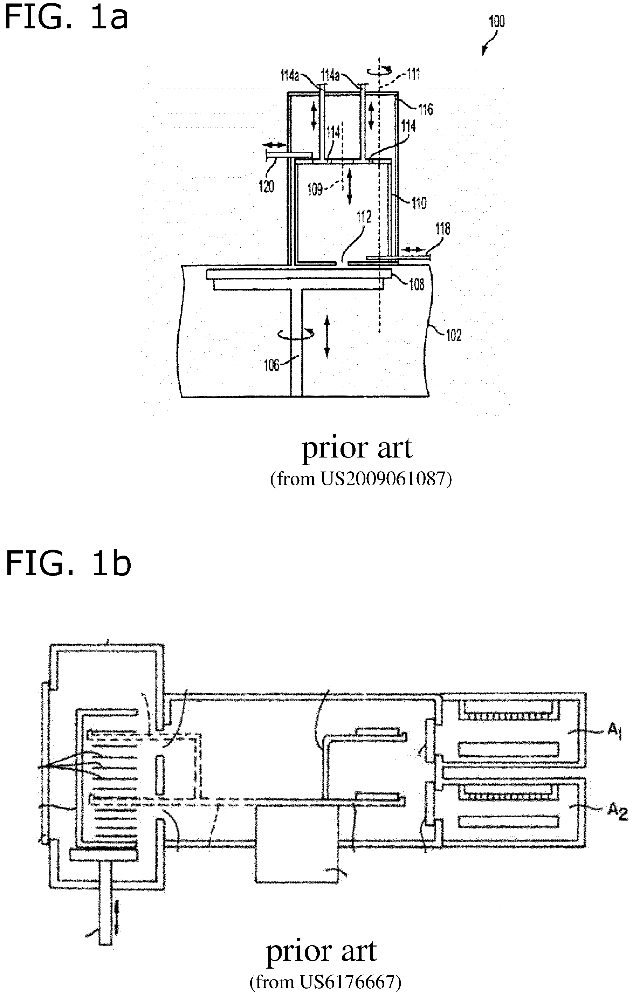

In US2009061087 a vacuum system is disclosed, showing processing chamber with a plurality of deposition means, for example CVD/ALD and PVD. Their deposition processes are commonly used in semi-conductor manufacturing to deposit a layer of material onto a substrate. Other applications are to manufacture integrated circuits (IC) semiconductor devices, flat panel displays, optoelectronics devices, data storage devices, magneto electronic or optic devices. Important is gradient processing, wherein different amounts of material (or dopant) is deposited across the entire substrate or a portion of the substrate. As shown in Fig. 1a the substrate can be processed in an integrated tool that allows both combinatorial and conventional processing in various chambers attached around a central chamber. With conventional processing in various chambers, techniques like PVD and ALD/CVD appear to refer to. By using a special substrate support as sample holder and a moveable base plate with opening, processing on defined regions of a single substrate are possible. In general masking of the sample surface with the movable base plate with many appertures is carried out. The substrate has to be at least rotatable and in alternatives also the one process head or the multiple process heads used have to be movable. US2009061087 also mentions, that the substrate should be linearly moved in x-y direction and/or be rotated to enable access to the entire surface through the relative aperture and substrate movement. As shown in Figure 1a of US2009061087 with the corresponding reference signs, a single chamber device with therein integrated sample holder and deposition means is used. For exposing the sample surface, sample holder and deposition means have to be rotatable and linearly movable inside the chamber. Of course the movability, in a linear, tilted and/or rotating way, of deposition means respectively deposition guns itself is disadvantageous, as the system and its control becomes more complex.

US6176667 shows another example of a vacuum system cluster tool, comprising at least two process chambers stacked one above the other. Such system is called multideck wafer processing system. The increased number of prepared wafers is achieved by stacking the process chambers one above another vertically. In the processing chambers different semiconductor treatments, for example physical vapour deposition or chemical vapour deposition can be applied. By transferring two (or more) wafers at a time from a wafer storing cassette or other means, the vertically arranged process chambers can be operated simultaneously. In a special embodiment a wafer transfer chamber for moving wafers from the wafer storage mechanism to the at least two chambers is used. It becomes clear from US6176667 that a wafer storage mechanism, stacked wafer processing chambers and a wafer transfer chamber are necessary. The wafer storage mechanism comprises an elevator for linear up and down movement, while at least one robot with at least one robot arm in the wafer transfer chamber is used for transfer of samples in form of wafers to the at least two processing chambers. Thus, several deposition steps can be carried out for treatment of a multiplicity of wafers. Some sample movements by means of a transfer mechanism are necessary to perform perhaps several dozens of different deposition or preparation steps. Such a vacuum system cluster tool is very complicated in structure, expensive and difficult to operate. Even if this vacuum system cluster tool and/or the process could be fully automated, there is a risk of errors due to the large number of sample movements. How exact the sample manipulation is, is not apparent from US6176667.

Vacuum system cluster tools are also known from CN 110 835 726 A and US 5 571 331 A.

### DESCRIPTION OF THE INVENTION

The object of the present invention is to provide a part of a vacuum system, named vacuum system cluster tool and a method as disclosed in the appended claims, which combines applicability of chemical vapour deposition (ALD and/or CVD) in a first chamber and physical vapour deposition (PVD) in a second chamber of the vacuum system cluster tool, whereby a compact inexpensive, simply constructed vacuum system cluster tool without mechanical sample transfer is created.

We avoid mechanical transfer means for the sample holder and a linear movement of the sample/sample holder in-situ between chambers. In our vacuum system cluster tool no linear movement or transfer of the sample or substrate is necessary. Therewith a more compact, inexpensive more easily operateable preparation vacuum system cluster tool is achievable, with possibility for full automation.

According to the prior art, always substrate transfer means and/or moveable deposition means were necessary in the known devices for transportation of sample and/or manipulation of deposition means after or between alternating preparation steps. Up to now, it has hardly been possible to carry out fully automated, multiple repetitive surface treatment controlled fully automatically by a control unit. Or if the sample/deposition means motion can be done in a controlled way, the preparation time was far too long to be commercially interesting.

### BRIEF DESCRIPTION OF THE DRAWINGS

Further understanding of various aspects of the invention can be obtained by reference to the following detailed description in conjunction with the associated drawings, which are described briefly below.

It should be noted that in the differently described embodiments, the same parts are provided with the same reference symbols or the same component names, the disclosures contained in the entire description being able to be applied analogously to the same parts with the same reference symbols or the same component symbols.

A preferred exemplary embodiment of the subject matter of the invention is described below in conjunction with the attached drawings.
- Figure 1a: shows a prior art vacuum system cluster tool with a cluster of process heads in a simplified schematic view, showing reference signs of the prior art document, while
- Figure 1b: shows another prior art vacuum system cluster tool form US6176667.
- Figure 2: shows a schematic perspective X-ray mode view of a vacuum system cluster tool with two processing chambers, directly separated by a gate valve between them.

### DESCRIPTION

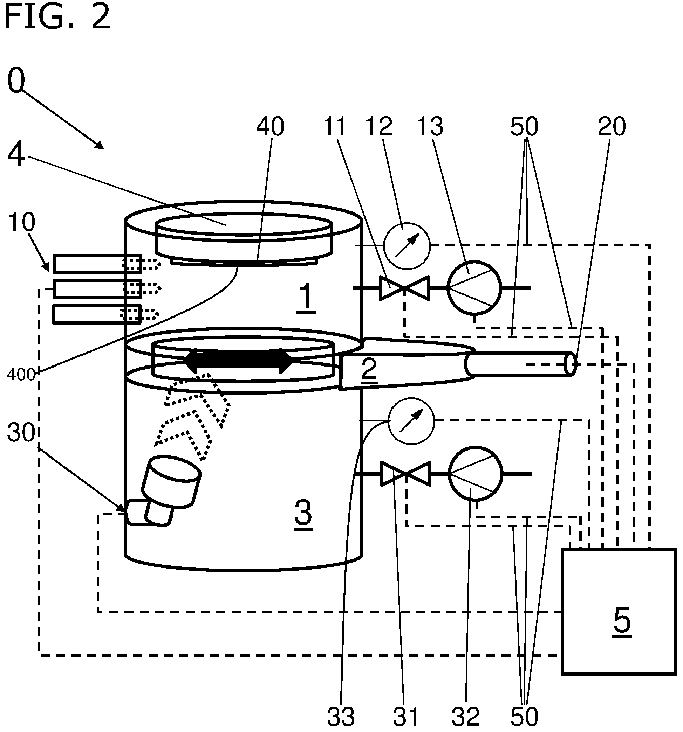

A vacuum system cluster tool 0 is shown here as an example in Figure 2, which usually includes further components and is part of a larger vacuum system. But the vacuum system cluster tool 0 can be used as described in the following for preparation of sample surfaces or surfaces 400 of substrates 40 using different vacuum preparation techniques. The fields of application have already been described in the state of the art section already.

The vacuum system cluster tool 0 is very compact and comprises at least a chemical vapour deposition chamber 1, a dividing gate valve 2, a physical vapour deposition chamber 3, a substrate holder 4 and at least one setup control unit 5 for controlling vacuum preparation.

The chemical vapour deposition chamber 1 and the physical vapour deposition chamber 3 are typical vacuum chambers 1, 3 as rigid enclosures from which air and other gases are removed by vacuum pumps 13, 32, which are controlled via electrical lines 50 by the setup control unit 5. This results in a low-pressure environment within the chamber 1, 3, commonly referred to as a vacuum, here HV or UHV with base pressures below 1x10⁻¹ Pa (1x10⁻³ mbar).

Each pump 13, 32 of each chamber 1, 3 is connected via valves 11, 31 connected to the chambers 1, 3, whereby the pressure prevailing inside the chamber 1, 3 can be read by connected pressure gauges 12, 33.

Chambers 1, 3 and also the separating gate valve 2, are typically predominantly made of metals and can be tempered for fast reaching low pressures. The flanges between chambers 1, 3 and the gate valve 2 have to be adapted to the vacuum to be reached.

Gate valves 2 are known and especially designed as spool valves, comprising a valve spool, providing a free passage when open fully releasing the nominal cross section.

Chemical vapour deposition is well known and abbreviated CVD, wherein ALD = atomic layer deposition is a subclass of chemical vapour deposition, wherein precursors react with the surface one at a time in a sequential, self-limiting manner.

Physical vapour deposition processes are widely known, wherein the most common PVD processes are sputtering and evaporation, producing thin films and coatings on substrate surfaces. In general is PVD characterized by processes in which material goes from a condensed phase to a vapor phase and then back to a thin film condensed phase. In general PVD processes are much faster than CVD processes.

The chemical vapour deposition chamber 1 is here called CVD/ALD chamber 1 and shows base pressures below 1 Pa (1x10⁻² mbar).

In particular this CVD/ALD chamber 1 is designed as an upper chamber, further away from the laboratory floor than other means of the vacuum system cluster tool 0. Vacuum-tight attached to the CVD/ALD chamber 1 is at least one precursor inlet 10, more preferably at least two precursor inlets 10, reaching in the CVD/ALD chamber 1. Gas precursors have to be introduced into the CVD/ALD chamber 1 in a controlled way, wherein chemical reactions of gas precursors, often used in a sequential way are leading to surface deposition. For fully automatic operation the precursor inlets 10, valve 11, pressure gauge 12 and pump 13 should be connected by the electrical lines 50 to the setup control unit 5. Precursor feeding and control of the pump 13 can be automatically monitored and controlled by the setup control unit 5.

The separating gate valve 2 is located physically between the CVD/ALD chamber 1 and the PVD chamber 3, directly without spacing. Here the gate valve 2 is connected on an upper side directly to the CVD/ALD chamber 1 and on a lower side directly to the PVD chamber 3. If the gate valve 2 is closed, CVD/ALD chamber 1 and PVD chamber 3 are not connected, keeping the vacuum by the their corresponding pumps 13, 32. In an open state of the gate valve 2 one common vacuum is formed in both chambers 1, 3 by the turbomolecular pump attached to the PVD in order to prevent back flow from the pump connected to the ALD. The ALD chamber is then closed to the pump connected to the ALD via an angle valve. 13, 32. The gate valve 2 should be connected by gate valve connections 20 to the setup control unit 5, forming an automatic motorized gate valve 2. With at least one setup control unit 5 even the gate valve 2 can be operated fully automatically and therewith the whole surface deposition method with a multiplicity of different deposition steps.

Chambers 1, 3 separated only by the gate valve 3, which are directly connected to each other, forming a single interior when the gate valve 3 is open, in which a vacuum is created.

Most preferred is the location of the substrate holder 4 in the CVD/ALD chamber 1, in which the substrate 40 can be loaded by a not shown load lock directly connected or integrated in the CVD/ALD chamber 1. In this setup the PVD chamber 3 is always kept under vacuum by closed gate valve 2, even while loading a substrate 40 to the substrate holder 4. The substrate holder 4 is controllably heatable to certain temperatures and/or can be designed rotatable about an axis, monitored and controlled by the setup control unit 5.

The pressure measurement by means of pressure gauges 12, 33, as well as the pumping with pumps 13, 32 is carried out by means known to the specialist in vacuum technology. For pressure measurement pressure gauges 12, 33 are used, where electrons are produced by a discharge or by emission of electrons, namely McLeod-vacuum-gauge, thermal conductivity gauges or Ionisation gauges.

Indistinctly, one can start with an CVD/ALD or a PVD process first. The whole vacuum system cluster tool 0 is automatized, for instance one can create a recipe to deposit n number of multi-nanolayers of both CVD/ALD and PVD materials.

### Example method

A surface deposition procedure with the vacuum system cluster tool 0 is explain in the following as an example.

For an CVD/ALD deposition, the gate valve 2 is closed and the process starts with the chosen amount of gas precursors. The CVD/ALD chamber 1 has its own vacuum pump 13. Once the desired number of cycles or film thickness is achieved, we perform a longer purging step to remove excess gases or adsorbed species from the walls of the CVD/ALD chamber 1. This can take from a few minutes to half an hour depending on the length of the ALD process.

To switch to a PVD process, we shut off all of the gas flow (Ar or N2) into the CVD/ALD chamber 1 to evacuate and reach a background pressure between 1x10⁻¹ and 1 Pa (1x10⁻⁶ and 1x10⁻² mbar), depends on the vacuum pump, once this pressure is reached then the exhaust valve of the CVD/ALD chamber 1 to its pump 13 is closed, then the gate valve 2 to the PVD chamber 3 is opened.

This process is automated and software controlled. The PVD chamber 3 that has been pumped between 1x10⁻⁶ and 1x10⁻⁵ Pa (1x10⁻⁸ and 1x10⁻⁷ mbar), can go up to 1x10⁻⁴ and 5x10⁻⁴ Pa (1x10⁻⁶ and 5x10⁻⁶ mbar) when opened, and depending on the length of the previous ALD process and subsequent purging step(and vacuum pumps) it can take from a few minutes to 30 minutes to reach about 5x10⁻⁵ Pa (5x10⁻⁷ mbar) after opening the gate valve 2.

Once the PVD chamber 3 reaches a defined pressure, then Ar is introduced into the chamber, plasma is ignited and the PVD process can start for the time set, depending of the material and thickness to be deposited by the physical vapour deposition mean 30, which is a magnetron here. Once the process is finished, then the gate valve 2 is closed, and the exhaust valve of the CVD/ALD chamber 1 can be opened, and the ALD/CVD process can start immediately.

This procedure can be repeated n number of times to deposit a wide range of multi-nanolayer materials with CVD/ALD and PVD.

This process is performed without any moving mechanical arms as the substrate 40 and the substrate holder 4 remain in the same place, because the substrate holder 4 remains permanently at the same position in relation to the chambers 1, 3 and the gate valve 2.

In this configuration, a substantial amount of time can be saved, and the risk of failure due to transfers with mechanical arms is minimized. This is especially true, when depositing hundreds of layers of each technique.

### Method in general

The vacuum system cluster tool 0 comprises a chamber-on-chamber setup, wherein the chambers 1, 3 respectively their interiors are divided and protected from each other via the gate valve 2. The substrate holder 4 is fixed in the top CVD/ALD chamber 1.
I. In a first step, at least one ALD/CVD process takes place with the gate valve 2 closed to protect the PVD chamber 3 / bottom chamber 3 from the gas precursors of the CVD/ALD process. The vacuum system cluster tool 0 is in the first step formed by an interior of a CVD chamber, which later can be switched to one interior in form of a PVD chamber, by opening the gate valve 2, without transfer of the substrate holder 4 from its initial position.
II. When the at least one ALD/CVD process is finished and after a while pumping the interior of the CVD/ALD chamber 1, the gate valve 2 will be opened to perform at least one further PVD process.
III. Without transfer of the substrate 40 in the substrate holder 4, at least one PVD process is carried out, preparing the surface 400 of the substrate 40 from the PVD chamber 3 through the gate valve 2 in the CVD/ALD chamber 1. The substrate 40, normally a wafer stays in the same position during CVD/ALD and PVD processes.

The gate valve 2 is automated to open and close when needed, controlled by the setup control unit 5. The opening and closing of the dividing gate valve 2 is schematically indicated by a double arrow, wherein the valve opening is closed in the closed state of the gate valve 2. This whole ensemble drastically reduces the time required to fabricate multilayers by ALD/CVD and PVD, as well as the equipment and operation costs.

The CVD/ALD chamber 1 and the PVD chamber 3 together with the dividing gate valve 2 show a chamber-on-chamber design, wherein both chambers 1, 3 can be positioned in any direction top/bottom or vertical/horizontal and can have any geometrical shape. Here the CVD/ALD chamber 1 is the top chamber 1 and the PVD chamber 3 is the bottom chamber 3 with gate valve 2 directly in between.

Here a load lock for loading substate 40 into the substate holder 4 is located in the upper CVD/ALD chamber 1.

For reaching a fully automated process, the setup control unit 5 can be programmed to automatically measure pressures via pressure gauges 12, 33, controlling the pumps 13, 32, feeding precursors into the CVD/ALD chamber 1, controlling a magnetron 30 in the PVD chamber 3 and automatically control the gate valve 2, for providing a fully automated process with a multiplicity of alternating CVD/ALD process steps and PVD process steps by setting the opening states of the valve.

For a faster switch between CVD/ALD process steps with closed gate valve 2 and PVD process step with open gate valve 2 at least the walls of the chemical vapour deposition chamber 1 should be heatable. At elevated Temperatures, the precursors can be much faster pumped out from the chemical vapour deposition chamber 1. Such tempering or heating means are not shown in Figure 2, but the person skilled in the art knows possibilities to heat up vacuum chamber walls and to locate such tempering or heating means at the walls of the CVD/ALD chamber 1 for accelerated pumping.

We are presenting the vacuum system cluster tool 0 that combines ALD/CVD with PVD in a compact cluster tool 0 without the need of several chambers or mechanical arms to move the sample. The at least one chemical vapour deposition chamber 1 and the at least one physical vapour deposition chamber 3 are divided by the gate valve 2 but directly connected on two opposite sides to the gate valve 2. In one step a CVD or ALD deposition step with closed valve onto the surface 400 and a subsequent PVD deposition after opening the gate valve 2 can be performed. The physical vapour deposition is carried out reaching through the physical vapour deposition chamber 3 and completely through the opening of the gate valve 3 onto the surface 400 of the substrate 40. Such steps can also be repeated in several cycles, whereby a substrate 40 transfer or linear substrate 40 movement is never necessary.

### LIST OF REFERENCE NUMERALS

0 vacuum system cluster tool
1 chemical vapour deposition = CVD/ALD chamber
   10 precursor inlet
   11 valve
   12 pressure gauge
   13 pump
2 gate valve
   20 gate valve connections
3 PVD chamber / lower chamber
   30 Magnetron
   31 valve
   32 pump
   33 pressure gauge
4 substrate holder
   40 substrate
   400 surface
5 setup control unit
   50 electrical lines

## Claims

1. A vacuum system cluster tool (0), comprising a dual chamber setup with at least one chemical vapour deposition chamber (1) and at least one physical vapour deposition chamber (3), with a substrate holder (4) located inside the vacuum system cluster tool (0), wherein the chemical vapour deposition chamber (1) possess corresponding chemical vapour deposition means (10, 11, 12, 13) attached and the physical vapour deposition chamber (3) comprises corresponding physical vapour deposition means (30, 31, 32, 33) attached, which are monitored and/or controlled by at least one setup control unit (5) for performing vacuum preparation of a substrate (40) on the substrate holder (4) inside the vacuum system cluster tool (0), **characterized in that** the at least one chemical vapour deposition chamber (1) and the at least one physical vapour deposition chamber (3) are divided by a gate valve (2) but directly connected on two opposite sides to the gate valve (2), and configured to perform a CVD or ALD preparation step with closed gate valve (2) onto the surface (400) and a subsequent PVD deposition after opening the gate valve (2), the PVD deposition being performed through the physical vapour deposition chamber (3) and completely through the opening of the gate valve (2) reaching into the interior of the chemical vapour deposition chamber (1) onto the surface (400) of the substrate (40), which can be repeated in severa cycles and whereby a substrate (40) transfer out of the chemical vapour deposition chamber (1) or a linear substrate (40) movement is not necessary.

2. Vacuum system cluster tool (0) according to claim 1, wherein the substrate holder (4) is located and immovably fixed in the interior of the chemical vapour deposition chamber (1).

3. Vacuum system cluster tool (0) according to claim 1, wherein the substrate holder (4) is rotatable but linearly fixed in the interior of the chemical vapour deposition chamber (1).

4. Vacuum system cluster tool (0) according to one of the preceding claims, wherein the gate valve (2) is designed to open and close fully automatically, controlled by the at least one setup control unit (5).

5. Vacuum system cluster tool (0) according to claim 3, wherein the setup control unit (5) is programmed to automatically measure pressures via pressure gauges (12, 33), controlling the pumps (13, 32), feeding precursors into the CVD/ALD chamber (1), controlling a plasma source (30) in the CVD/ALD and/or PVD chamber (3) and automatically control the gate valve (2), for providing a fully automated process with a multiplicity of alternating CVD/ALD process steps and PVD process steps by setting the opening states of the valve.

6. Vacuum system cluster tool (0) according to one of the preceding claims, wherein the CVD/ALD chamber (1) and the PVD chamber (3) together with the dividing gate valve (2) show a chamber-on-chamber design, wherein the CVD/ALD chamber (1) is the top chamber and the PVD chamber (3) is the bottom chamber with the gate valve (2) placed directly between both chambers (1, 3).

7. Vacuum system cluster tool (0) according to one of the preceding claims, wherein tempering or heating means are located at least partly surrounding the walls of the CVD/ALD chamber (1) for accelerated pumping out of the CVD/ALD chamber (1) before opening the gate valve (2).

8. Vacuum system cluster tool (0) according to one of the preceding claims, wherein a load lock for loading the substrate (40) into the substrate holder (4) is located in the chemical vapour deposition chamber (1).

9. Vacuum system cluster tool (0) according to one of the preceding claims, wherein the substrate holder (4) remains permanently at the same position in relation to the chambers (1, 3) and the gate valve (2), while the only in-situ linearly movable component of the vacuum system cluster tool (0) is the valve spool of the gate valve (2), controlled by the setup control unit (5).

10. Vacuum system cluster tool (0) according to one of the preceding claims, wherein the substrate holder (4) is heatable to certain temperatures monitored and controlled by the setup control unit (5).

11. Method for performing at least one chemical vapour deposition process step and at least one subsequent physical vapour deposition process step with a vacuum system cluster tool (0) according to one of the preceding claims, **wherein** fully automatically and controlled by the setup control unit (5)
- the at least one chemical deposition process step is performed with the gate valve (2) in a closed state, while the interior of the vacuum system cluster tool (0) is formed by the interior of the chemical vapour deposition chamber (1),
- after finished the chemical deposition step a pumping of the interior of the chemical vapour deposition chamber (1) to a sufficient base pressure of about 5x10⁻¹ Pa (5x10⁻³ mbar) is carried out, before
- the gate valve (2) is opened, and without transfer of the substrate holder (4) from its initial position
- a subsequent physical deposition step is performed through the physical deposition chamber (3) with physical deposition means, through the opening of the gate valve (2) reaching into the interior of the chemical vapour deposition chamber (1).

12. Method according claim 11, wherein after the chemical deposition step a purging step is performed to remove excess gases or adsorbed species from the walls of the CVD/ALD chamber (1).

## Patentansprüche

1. Vakuumsystemclusterwerkzeug (0), umfassend eine Doppelkammeranordnung mit mindestens einer Kammer (1) für die chemische Gasphasenabscheidung und mindestens einer Kammer (3) für die physikalische Gasphasenabscheidung, mit einem Substrathalter (4), der sich innerhalb des Vakuumsystemclusterwerkzeugs (0) befindet, wobei die Kammer (1) für die chemische Gasphasenabscheidung entsprechende chemische Gasphasenabscheidungsmittel (10, 11, 12, 13) aufweist und die physikalische Gasphasenabscheidungskammer (3) entsprechende physikalische Gasphasenabscheidungsmittel (30, 31, 32, 33) aufweist, die von mindestens einer Anlagesteuereinheit (5) überwacht und/oder gesteuert werden, um eine Vakuumvorbereitung eines Substrats (40) auf dem Substrathalter (4) innerhalb des Vakuumsystemclusterwerkzeugs (0) durchzuführen, **dadurch gekennzeichnet, dass** die mindestens eine chemische Gasphasenabscheidungskammer (1) und die mindestens eine physikalische Gasphasenabscheidungskammer (3) durch ein Absperrventil (2) getrennt sind, jedoch an zwei gegenüberliegenden Seiten des Absperrventils (2) direkt miteinander verbunden sind, und konfiguriert sind, ein CVD- oder ALD-Vorbereitungsschritt bei geschlossenem Absperrventil (2) auf die Oberfläche (400) und eine anschliessende PVD-Abscheidung nach Öffnen des Absperrventils (2) durchzuführen, wobei die PVD Abscheidung durch die physikalische Gasphasenabscheidungskammer (3) und vollständig durch die Öffnung des Absperrventils (2) hindurch in das Innere der chemischen Gasphasenabscheidungskammer (1) reichend auf die Oberfläche (400) des Substrats (40) durchgeführt wird, was in mehreren Zyklen wiederholt werden kann und wobei ein Substrattransfer (40) aus der chemischen Gasphasenabscheidungskammer (1) oder eine lineare Substratbewegung (40) nicht erforderlich ist.

2. Vakuumsystemclusterwerkzeug (0) nach Anspruch 1, wobei der Substrathalter (4) im Inneren der chemischen Gasphasenabscheidungskammer (1) angeordnet und unbeweglich befestigt ist.

3. Vakuumsystemclusterwerkzeug (0) nach Anspruch 1, wobei der Substrathalter (4) drehbar, aber linear im Inneren der chemischen Gasphasenabscheidungskammer (1) fixiert ist.

4. Vakuumsystemclusterwerkzeug (0) nach einem der vorstehenden Ansprüche, wobei das Absperrventil (2) so ausgelegt ist, dass es vollautomatisch öffnet und schliesst, gesteuert durch die mindestens eine Anlagesteuereinheit (5).

5. Vakuumsystemclusterwerkzeug (0) nachAnspruch 3, wobei die Anlagesteuereinheit (5) so programmiert ist, dass sie automatisch Drücke über Manometer (12, 33) misst, die Pumpen (13, 32) steuert, Vorläufer in die CVD/ALD-Kammer (1) einspeist, eine Plasmaquelle (30) in der CVD/ALD- und/oder PVD-Kammer (3) steuerte und automatisch das Absperrventil (2) steuert, um einen vollautomatischen Prozess mit einer Vielzahl von abwechselnden CVD/ALD-Prozessschritten und PVD-Prozessschritten durch Einstellen der Öffnungszustände des Ventils bereitzustellen

6. Vakuumsystemclusterwerkzeug (0) nach einem der vorstehenden Ansprüche, wobei die CVD/ALD-Kammer und die PVD-Kammer (3) zusammen mit dem Absperrventil (2) eine Kammer-auf-Kammer-Konstruktion aufweisen, wobei die CVD/ALD-Kammer (1) die obere Kammer und die PVD-Kammer (3) die untere Kammer ist, wobei das Absperrventil (2) direkt zwischen beiden Kammern (1, 3) angeordnet ist.

7. Vakuumsystemclusterwerkzeug (0) nach einem der vorstehenden Ansprüche, wobei Temperier- oder Heizmittel zumindest teilweise um die Wände der CVD/ALD-Kammer (1) herum angeordnet sind, um das Auspumpen der CVD/ALD-Kammer (1) vor dem Öffnen des Absperrventils (2) zu beschleunigen.

8. Vakuumsystemclusterwerkzeug (0) nach einem der vorstehenden Ansprüche, wobei sich eine Ladeschleuse zum Laden des Substrats (40) in den Substrathalter (4) in der chemischen Gasphasenabscheidungskammer (1) befindet.

9. Vakuumsystemclusterwerkzeug (0) nach einem der vorstehenden Ansprüche, wobei der Substrathalter (4) permanent in derselben Position in Bezug auf die Kammern (1, 3) und das Absperrventil (2) verbleibt, während die einzige linear bewegliche Komponente des Vakuumsystemclusterwerkzeugs (0) der Ventilschieber des Absperrventils (2) ist, der von der Anlagesteuereinheit (5) gesteuert wird.

10. Vakuumsystemclusterwerkzeug (0) nach einem der vorstehenden Ansprüche, wobei der Substrathalter (4) auf bestimmte Temperaturen beheizbar ist, die von der Anlagesteuereinheit (5) überwacht und gesteuert werden.

11. Verfahren zur Durchführung mindestens eines chemischen Gasphasenabscheidungsprozessschritts und mindestens eines nachfolgenden physikalischen Gasphasenabscheidungsprozessschritts mit einem Vakuumsystemclusterwerkzeug (0) nach einem der vorstehenden Ansprüche,
**wobei**
vollautomatisch und gesteuert durch die Anlagesteuereinheit (5)
- der mindestens eine chemische Abscheidungsprozessschritt mit dem Absperrventil (2) in geschlossenem Zustand durchgeführt wird, während der Innenraum des Vakuumsystemclusterwerkzeugs (0) durch den Innenraum der chemischen Gasphasenabscheidungskammer (1) gebildet wird,
- nach Beendigung des chemischen Abscheidungsschritts ein Abpumpen des Innenraums der chemischen Gasphasenabscheidungskammer (1) auf einen ausreichenden Basisdruck von etwa 5x10⁻¹ Pa (5 x 10⁻³ mbar) durchgeführt wird, bevor
- das Absperrventil (2) geöffnet wird,
und ohne Übertragung des Substrathalters (4) aus seiner Ausgangsposition
- ein nachfolgender physikalischer Abscheidungsschritt durch die physikalische Gasphasenabscheidungskammer (3) hindurch in das Innere der chemischen Gasphasenabscheidungskammer (1) reichend mit physikalischen Gasphasenabscheidungsmitteln durchgeführt wird, indem das Absperrventil (2) geöffnet wird.

12. Verfahren nach Anspruch 11, wobei nach dem chemischen Abscheidungsschritt ein Spülschritt durchgeführt wird, um überschüssige Gase oder adsorbierte Spezies von den Wänden der CVD/ALD-Kammer (1) zu entfernen.

## Revendications

1. Dispositif de regroupement de système sous vide (0), comprenant une configuration à double chambre présentant au moins une chambre de dépôt chimique en phase vapeur (1) et au moins une chambre de dépôt physique en phase vapeur (3), avec un support de substrat (4) situé à l'intérieur du dispositif de regroupement de système sous vide (0), dans lequel la chambre de dépôt chimique en phase vapeur (1) comprend des moyens de dépôt chimique en phase vapeur correspondants (10, 11, 12, 13) attachés et la chambre de dépôt physique en phase vapeur (3) comprend des moyens de dépôt physique en phase vapeur correspondants (30, 31, 32, 33) attachés, qui sont contrôlés et/ou commandés par le biais d'au moins une unité de commande de configuration (5) pour effectuer une préparation sous vide d'un substrat (40) sur le support de substrat (4) à l'intérieur du dispositif de regroupement de système sous vide (0), **caractérisé en ce que** l'au moins une chambre de dépôt chimique en phase vapeur (1) et l'au moins une chambre de dépôt physique en phase vapeur (3) sont séparées par une vanne d'arrêt (2) mais sont directement raccordées sur deux côtés opposés à la vanne d'arrêt (2), et sont configurées pour effectuer une étape de préparation CVD ou ALD avec la vanne d'arrêt fermée (2) sur la surface (400) et un dépôt PVD subséquent après l'ouverture de la vanne d'arrêt (2), le dépôt PVD étant effectué à travers la chambre de dépôt physique en phase vapeur (3) et complètement de par l'ouverture de la vanne d'arrêt (2) atteignant l'intérieur de la chambre de dépôt chimique en phase vapeur (1) sur la surface (400) du substrat (40), qui est réitérable en plusieurs cycles et pour laquelle ni un transfert de substrat (40) hors de la chambre de dépôt chimique en phase vapeur (1) ni un mouvement linéaire de substrat (40) ne sont nécessaires.

2. Dispositif de regroupement de système sous vide (0) selon la revendication 1, dans lequel le support de substrat (4) est situé et fixé de manière immobile à l'intérieur de la chambre de dépôt chimique en phase vapeur (1).

3. Dispositif de regroupement de système sous vide (0) selon la revendication 1, dans lequel le support de substrat (4) est pivotant mais fixé de manière linéaire à l'intérieur de la chambre de dépôt chimique en phase vapeur (1).

4. Dispositif de regroupement de système sous vide (0) selon l'une des revendications précédentes, dans lequel la vanne d'arrêt (2) est conçue pour s'ouvrir et se fermer de manière entièrement automatique, commandée par l'au moins une unité de commande de configuration (5).

5. Dispositif de regroupement de système sous vide (0) selon la revendication 3, dans lequel l'unité de commande de configuration (5) est programmée pour mesurer automatiquement des pressions via des manomètres (12, 33), pour commander les pompes (13, 32), pour alimenter des précurseurs dans la chambre CVD/ALD (1), pour commander une source de plasma (30) dans la chambre CVD/ALD et/ou PVD (3), pour commander automatiquement la vanne d'arrêt (2), ainsi que pour fournir un processus entièrement automatisé avec une multiplicité d'étapes de processus CVD/ALD et d'étapes de processus PVD alternées en réglant les états d'ouverture de la vanne.

6. Dispositif de regroupement de système sous vide (0) selon l'une des revendications précédentes, dans lequel la chambre CVD/ALD (1) et la chambre PVD (3) conjointement avec la vanne d'arrêt de séparation (2) présentent une conception de type chambre sur chambre, dans lequel la chambre CVD/ALD (1) est la chambre supérieure et la chambre PVD (3) est la chambre inférieure avec la vanne d'arrêt (2) placée directement entre les deux chambres (1, 3).

7. Dispositif de regroupement de système sous vide (0) selon l'une des revendications précédentes, dans lequel des moyens de tempérage ou de chauffage sont situés au moins partiellement autour des parois de la chambre CVD/ALD (1) afin d'accélérer un pompage hors de la chambre CVD/ALD (1) avant l'ouverture de la vanne d'arrêt (2).

8. Dispositif de regroupement de système sous vide (0) selon l'une des revendications précédentes, dans lequel un sas de chargement pour charger le substrat (40) dans le support de substrat (4) est situé dans la chambre de dépôt chimique en phase vapeur (1).

9. Dispositif de regroupement de système sous vide (0) selon l'une des revendications précédentes, dans lequel le support de substrat (4) reste en permanence à la même position par rapport aux chambres (1, 3) et à la vanne d'arrêt (2), tandis que le seul composant mobile de manière linéaire in situ du dispositif de regroupement de système sous vide (0) est le tiroir de vanne de la vanne d'arrêt (2), commandé par l'unité de commande de configuration (5).

10. Dispositif de regroupement de système sous vide (0) selon l'une des revendications précédentes, dans lequel le support de substrat (4) est configuré de manière à pouvoir être chauffé à certaines températures contrôlées et commandées par l'unité de commande de configuration (5).

11. Procédé pour réaliser au moins une étape de procédé de dépôt chimique en phase vapeur et au moins une étape de procédé de dépôt physique en phase vapeur subséquente avec un dispositif de regroupement de système sous vide (0) selon l'une des revendications précédentes, **dans lequel** de manière entièrement automatique et commandée par l'unité de commande de configuration (5)
- l'au moins une étape de procédé de dépôt chimique est réalisée avec la vanne d'arrêt (2) dans un état fermé, tandis que l'intérieur du dispositif de regroupement de système sous vide (0) est formé par l'intérieur de la chambre de dépôt chimique en phase vapeur (1),
- après la fin de l'étape de dépôt chimique, un pompage de l'intérieur de la chambre de dépôt chimique en phase vapeur (1) jusqu'à une pression de base suffisante d'environ 5 x 10⁻¹ Pa (5 x 10⁻³ mbar) est réalisé, avant
- l'ouverture de la vanne d'arrêt (2), et sans transfert du support de substrat (4) par rapport à sa position initiale
- une étape de dépôt physique subséquente est effectuée à travers la chambre de dépôt physique (3) avec des moyens de dépôt physique, de par l'ouverture de la vanne d'arrêt (2) atteignant l'intérieur de la chambre de dépôt chimique en phase vapeur (1).

12. Procédé selon la revendication 11, dans lequel après l'étape de dépôt chimique, une étape de purge est effectuée afin d'éliminer des gaz en excès ou des espèces adsorbées provenant des parois de la chambre CVD/ALD (1).
